# EUROPEAN PATENT APPLICATION

(11) **EP 4 528 295 A1**
(43) Date of publication of application: **26.03.2025**
(21) Application number: 24201314.2
(22) Date of filing: 19.09.2024
(51) Int. Cl.: G01R 31/3185, G06F 30/33, G01R 31/3177, G01R 31/3181

(54) **IDENTIFICATION OF A FAULT IN A FINITE STATE MACHINE**

(30) Priority: 22.09.2023 GB 202314607
(71) Applicant: Imagination Technologies Limited, Kings Langley, Hertfordshire WD4 8LZ (GB)
(72) Inventor: Carville, Christopher William Harkness, Kings Langley, WD4 8LZ (GB)
(74) Representative: Slingsby Partners LLP

(57) **Abstract**

There is provided a computer-implemented method and a processing module for identifying that a fault has occurred in a finite-state machine (FSM). It is determined whether a set of one or more transitions that have occurred between states of the FSM is allowable. In response to determining that the set of one or more transitions is not allowable, it is identified that a fault has occurred in the FSM.

## Description

### CROSS-REFERENCE TO RELATED APPLICATION

This application claims priority from UK patent application 2314607.9 filed on 22 September 2023, which is herein incorporated by reference in its entirety.

### TECHNICAL FIELD

The present disclosure relates to identification of a fault in a finite-state machine.

### BACKGROUND

Finite-state machines are known in the art. A finite-state machine (FSM) represents a system as a finite series of states. The system can only be in one state of the finite number of states at a time. The system can transition from being in one state to another state depending on the inputs received. FSMs are often used to model and implement circuit behaviour in hardware. Outputs from states within the FSM can be used to drive separate functionality in a system, such as a safety-critical system.

Sometimes faults can arise in the FSM due to errors in the hardware running the FSM. Errors in hardware can arise for a variety of reasons, such as electro-magnetic interference from a cosmic ray or a solar flare. Some faults, called transient faults, occur as one-off events. For example, a solar flare may cause an element of the hardware to output a 0 instead of a 1. Once the cause of the transient fault has been removed, that same error is not repeated in the hardware. A different type of fault common to hardware is a "stuck-at-fault". Once a stuck-at-fault has occurred, the hardware will repeat that fault even after the cause of the fault has been removed. For example, a stuck-at-fault may cause an element of the hardware to always output a 1, so it is "stuck-at" 1. Stuck-at-faults can occur due to silicon aging or fabrication error. In digital logic, stuck-at-faults are classified as either "Stuck-At-0" (SA0) or "Stuck-At-1" (SA1).

Faults in hardware such as transient and stuck-at-faults can occur during runtime even when there are no errors in the design of the hardware. Furthermore, these faults can be difficult to detect. It is important to be able to detect such faults, particularly when the FSM is implemented in a safety-conscious (or "safety-critical") system. Safety-conscious systems must usually comply with certain safety standards. For example, in the automotive industry, systems must comply with the relevant Automotive Safety Integrity Level (ASIL). Being able to detect or mitigate hardware errors such as stuck-at faults is a requirement for achieving a certain functional safety standard, such as the IS0 26262 standard.

One method for mitigating random hardware faults during runtime is to include a certain degree of redundancy in the system. By adding redundancy into the hardware (e.g. by duplicating some portions of the hardware), it is less likely for a random error to happen to both the main components and the redundant components at the same time. However, additional redundant units take up more silicon area in the hardware and consume more power. It is often desirable to reduce the power consumption and silicon area of computing systems.

Logic built-in self-test (BIST) methods are another technique for mitigating errors in the hardware so as to comply with certain safety standards. Logic-BIST methods involve adding specific circuitry to the hardware to perform self-tests on the hardware. Such methods are invasive to both hardware and run-time applications as the whole chip (or large sections) may be tested. Logic-BIST methods also take up more silicon area in the hardware and can be expensive to implement.

### SUMMARY

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

There is provided a computer-implemented method of identifying that a fault has occurred in a finite-state machine (FSM), the method comprising determining whether a set of one or more transitions that have occurred between states of the FSM is allowable, and in response to determining that the set of one or more transitions is not allowable, identifying that a fault has occurred in the FSM.

Said determining may be performed in dependence on a data record comprising at least one predefined set of one or more transitions.

Said determining may comprise comparing the set of one or more transitions that have occurred between states of the FSM with the data record comprising the at least one predefined set of one or more transitions, and determining that the set of one or more transitions is not allowable in response to said comparison.

Each of the at least one predefined set of one or more transitions may be an allowable set of one or more transitions between states of the FSM.

Each of the at least one predefined set of one or more transitions may be an unallowable set of one or more transitions between states of the FSM.

A first group may comprise predefined allowable sets of one or more transitions between states of the FSM. A second group may comprise predefined unallowable sets of one or more transitions between states of the FSM. The data record may comprise the sets of the group comprising the fewest predefined sets out of the first and second groups.

The number of transitions in the set of one or more transitions that have occurred may be equal to the number of transitions in one of the at least one predefined set of one or more transitions in the data record.

The method may further comprise recording the set of one or more transitions that have occurred between states of the FSM in a transition history.

Said determining may be performed in dependence on the transition history.

The transition history may be configured to record up to a maximum number of transitions.

The number of transitions in the set of one or more transitions that have occurred may not exceed the maximum number.

The maximum number of transitions may be determined based on the at least one predefined set of one or more transitions in the data record.

Said determining may be performed in response to detecting that the number of transitions that have occurred is equal to the number of transitions in one of the at least one predefined set of one or more transitions in the data record.

The method may be performed whilst the FSM is active and responding to input data.

The method may further comprise, in response to identifying that a fault has occurred in the FSM: replaying the FSM from a first state corresponding to a first transition in the set of one or more transitions that have occurred; and, in response to determining that the same set of one or more transitions has occurred between states of the FSM, determining that the fault that has occurred is a stuck-at-fault.

There is provided a processing module configured to identify that a fault has occurred in a finite-state machine (FSM), the processing module comprising a verification unit configured to determine whether a set of one or more transitions that have occurred between states of the FSM is allowable; and a fault signalling unit configured to identify that a fault has occurred in the FSM if the verification unit indicates that the set of one or more transitions is not allowable.

The verification unit may be configured to perform said determining in dependence on a data record comprising at least one predefined set of one or more transitions.

The verification unit may be configured to perform said determining by comparing the set of one or more transitions that have occurred between states of the FSM with the data record comprising the at least one predefined set of one or more transitions; and determining that the set of one or more transitions is not allowable in response to said comparison.

The verification unit may be configured to perform said determining in response to detecting that the number of transitions that have occurred is equal to the number of transitions in one of the at least one predefined set of one or more transitions in the data record.

The processing module may comprise a memory configured to record the set of one or more transitions that have occurred between states in the FSM in a transition history.

The verification unit may be configured to perform said determining in dependence on the transition history stored in the memory.

The memory may be configured to record up to a maximum number of transitions, wherein the maximum number is determined based on the at least one predefined set of one or more transitions in the data record.

The number of transitions in the set of one or more transitions that have occurred may not exceed the maximum number.

There may be provided computer readable code configured to cause any of the methods described herein to be performed when the code is run.

There may be provided an integrated circuit definition dataset that, when processed in an integrated circuit manufacturing system, configures the integrated circuit manufacturing system to manufacture a processing module as described herein.

The processing module may be embodied in hardware on an integrated circuit. There may be provided a method of manufacturing, at an integrated circuit manufacturing system, a processing module. There may be provided an integrated circuit definition dataset that, when processed in an integrated circuit manufacturing system, configures the system to manufacture a processing module. There may be provided a non-transitory computer readable storage medium having stored thereon a computer readable description of a processing module that, when processed in an integrated circuit manufacturing system, causes the integrated circuit manufacturing system to manufacture an integrated circuit embodying a processing module.

There may be provided an integrated circuit manufacturing system comprising: a non-transitory computer readable storage medium having stored thereon a computer readable description of the processing module; a layout processing system configured to process the computer readable description so as to generate a circuit layout description of an integrated circuit embodying the processing module and an integrated circuit generation system configured to manufacture the processing module according to the circuit layout description.

There may be provided computer program code for performing any of the methods described herein. There may be provided non-transitory computer readable storage medium having stored thereon computer readable instructions that, when executed at a computer system, cause the computer system to perform any of the methods described herein.

The above features may be combined as appropriate, as would be apparent to a skilled person, and may be combined with any of the aspects of the examples described herein.

### BRIEF DESCRIPTION OF THE DRAWINGS

Examples will now be described in detail with reference to the accompanying drawings in which:
Figure 1 shows an example state diagram for a finite-state machine.
Figure 2 shows a method for fault detection as described herein.
Figure 3 shows an example transition history.
Figure 4 shows an example transition history.
Figure 5 shows a method 500 that can be performed as part of step S240.
Figure 6 shows an example state diagram for a finite-state machine comprising conditional transitions.
Figure 7 shows a processing module configured to identify that a fault has occurred in a finite-state machine.
Figure 8 shows a computer system in which a processing module is implemented on a graphics processing system.
Figure 9 shows an integrated circuit manufacturing system for generating an integrated circuit embodying a processing module.

The accompanying drawings illustrate various examples. The skilled person will appreciate that the illustrated element boundaries (e.g., boxes, groups of boxes, or other shapes) in the drawings represent one example of the boundaries. It may be that in some examples, one element may be designed as multiple elements or that multiple elements may be designed as one element. Common reference numerals are used throughout the figures, where appropriate, to indicate similar features.

### DETAILED DESCRIPTION

The following description is presented by way of example to enable a person skilled in the art to make and use the invention. The present invention is not limited to the embodiments described herein and various modifications to the disclosed embodiments will be apparent to those skilled in the art.

Embodiments will now be described by way of example only.

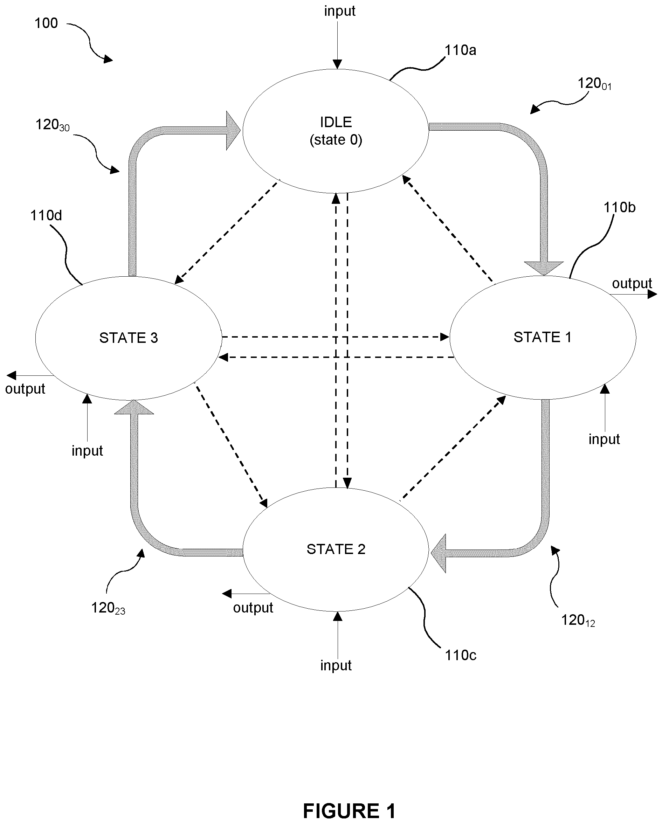

An example state diagram 100 for a finite-state machine (FSM) is depicted in figure 1. An FSM can be in (exactly) one of a finite number of states at any given time. The FSM can transition between states in response to certain inputs. An FSM must comprise at least two states. In other words, the FSM comprises a plurality of states. In the example shown in figure 1, the FSM 100 comprises four states: 110a, 110b, 110c, 110d, including an idle state 110a.

The FSM is arranged to receive an input when it is in each of the states. In some states, the FSM is also arranged to produce an output. Not all states in an FSM necessarily have an output. For example, in figure 1 when the FSM is in the idle state 110a it does not output anything.

The FSM can only be in one state at a time. The FSM can transition from being in one state to being in another state in response to certain inputs. A transition 120 defines a progression of the FSM from one state to another state. Each shaded arrow 120₀₁, 120₁₂, 120₂₃, 120₃₀, in figure 1 depicts a transition between states. The first digit of the subscript of each label 120 depicts the state from which the transition starts, and the second digit of the subscript of each label 120 depicts the state at which the transition ends. For example, transition 120₂₃ is a transition from state 2 to state 3. In this example, the idle state is labelled as state 0.

A transition represents a direct route from one state to another state. In other words, a transition cannot involve more than two states. The progression from state 1 to state 2 to state 3, for example, involves two transitions: a transition 120₁₂ from state 1 to state 2, and another transition 120₂₃ from state 2 to state 3. A transition has a direction. For example, a transition from the idle state to state 1 (120₀₁) is a different transition to the transition from state 1 to the idle state. So, a transition is defined by the two states between which the transition occurs, and the direction in which that transition occurs.

Whether or not a transition occurs from a current state to another state depends on the input to the FSM. For example, in a particular FSM, the FSM may be configured to transition from the idle state to state 1 only when the FSM receives an input equal to 1 when it is in the idle state. If the FSM, when in the idle state, receives an input that is equal to anything other than 1 (for example), it may remain in the idle state. As another example, the FSM may transition from state 1 to state 2 only if it receives an input that is greater than 1. If the FSM, when in state 1, receives an input that is not greater than 1, it will do nothing.

When the FSM is designed, the possible transitions between states in response to certain inputs are planned out by a designer. An FSM is created with intentional transitions between states that occur in response to certain inputs. For example, in the FSM with the state diagram shown in figure 1, it is intended that there could be a transition between the idle state and state 1, when a certain input is received when the FSM is in the idle state. It is also intended that there could be a transition from state 3 to the idle state. The intended transitions are predetermined transitions that are expected to occur during normal operation of the FSM. That is, for the purposes of this document, intended transitions are those that the FSM allows according to the actual (i.e. coded) design of FSM (irrespective of whether that design reflects the desired functionality that the designer intended to create). An intended transition may be called an allowable transition herein. There are a finite number of allowable transitions in an FSM.

When the FSM is designed and the allowable transitions between states are determined, there are usually some transitions between states that are not supposed to happen, regardless of the inputs. Usually, an FSM is not designed to include every possible transition between states as an allowable transition. Some transitions between states are not intended to occur under any circumstances, assuming the FSM is operating correctly. Transitions that are not envisaged by the designer of the FSM are depicted with dashed arrows in figure 1. For example, it is not intended for there to be a transition between the idle state and state 2. In other words, when the FSM was created, there was no input for which a transition between the idle state and state 2 was expected to occur. Similarly, there was no input for which a transition from state 1 to state 3 was expected to occur. An unintended transition may be called an unallowable transition herein. There are a finite number of unallowable transitions.

In some examples (e.g. the example shown in figure 1), a transition is either allowable, or it is unallowable, i.e. there are no other types of transitions. So, in these examples, the unallowable transitions can be determined from the allowable transitions, and vice versa.

The allowable and unallowable transitions between states are predetermined. For example, the allowable and unallowable transitions are determined by a programmer when designing the FSM. The allowable and unallowable transitions have already been determined when the FSM is active and responding to inputs. For example, the allowable and unallowable transitions are determined during a design-phase of the FSM.

Table 1 shows the allowable transitions and the unallowable transitions of the FSM having the state diagram shown in figure 1.

**Table 1**

| **Allowable transitions** | **Unallowable transitions** |
|---|---|
| Idle state → state 1 | State 1 → idle state |
| State 1 → state 2 | State 1 → state 3 |
| State 2 → state 3 | State 2 → idle state |
| State 3 → idle state | State 2 → state 1 |
| | State 3 → state 1 |
| | State 3 → state 2 |
| | Idle state → state 3 |
| | Idle state → state 2 |

In some FSMs, such as the one described above with reference to figure 1, the allowability of a transition is independent of any previous or future transitions that occur in the FSM.

It may be the case that an FSM is designed such that a transition between two states is conditional on one or more previous or future transitions. Such transitions may be referred to herein as conditional transitions. A conditional transition cannot be said to be allowable on its own, because its allowability depends on a preceding or following transition. Instead of the FSM being designed with allowable transitions, it can be thought of as being designed with allowable routes, where a route can include multiple transitions. The conditional transitions are part of a route comprising at least two transitions.

A route is a set of one or more transitions. For example, a route may be only one transition. For example, a route may be a set of one transition. For example, a route ("route A") may be from state 1 to state 2, which is shown as transition 120₁₂ in figure 1. In another example, a route may be a set of two or more transitions. For example, a route ("route B") may be from state 1 to state 2 to state 3, which is shown as transition 120₁₂ and transition 120₂₃ in figure 1. In this case, route B from state 1 to state 3 proceeds via state 2 and includes two transitions. A route and a set of one or more transitions are used interchangeably herein.

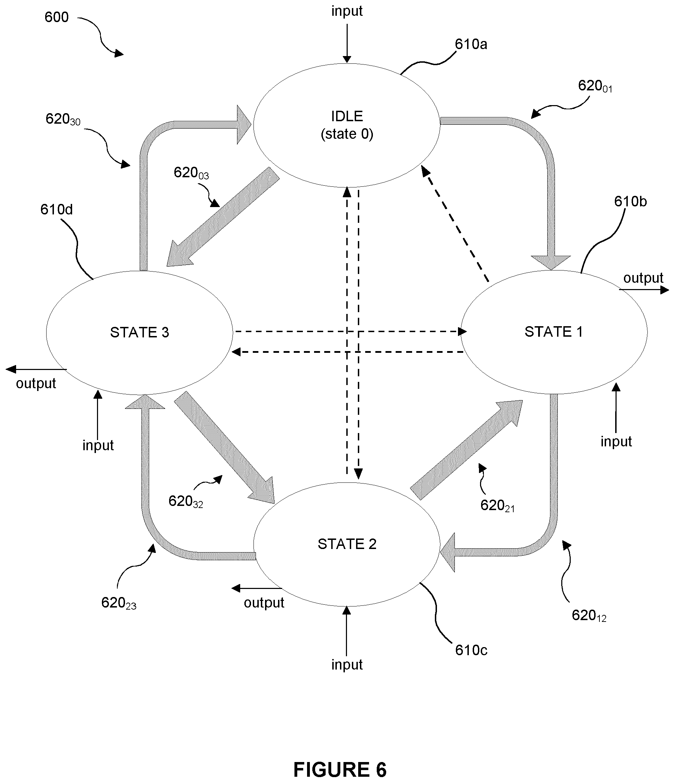

Figure 6 shows an example state diagram 600 for an FSM which will be used to further explain conditional transitions.

Some allowable routes (i.e. predefined sets of one or more transitions) are depicted with shaded arrows, as in figure 1. Some of the unallowable routes are depicted with dashed arrows, as in figure 1. Not all of the unallowable routes are shown in figure 6. Table 2 shows the allowable and unallowable routes of the FSM having the state diagram 600 shown in figure 6.

In this example, a transition 620₁₂ from state 1, 610b, to state 2, 610c, is allowed. A transition from state 2, 610c, to state 1, 610b, is allowed if the preceding transition was from state 1 to state 2. So, the transition 620₂₁ is an example of a conditional transition. Another example of a conditional transition is the transition from state 3 to state 2 (transition 620₃₂). This transition is only allowed if the next transition is back to state 3. In this example, the FSM does not allow a route from state 3 to state 2 to state 1. The only condition under which state 3 to state 2 is allowable is if the route goes back to state 3 again, so that the route becomes state 3 to state 2 to state 3. Similarly, in this example, the transition from the idle state to state 3 is only allowed if that transition is followed by a return to the idle state. So, the route ("route C") from state 3 to the idle state to state 3 is allowable. However, the route ("route D") from the idle state to state 3 to state 2, for example, is not allowable.

**Table 2-1**

| **Set No.** | **Allowable sets of one or more transitions** |
|---|---|
| 1 | Idle state → state 1 |
| 2 | State 1 → state 2 |
| 3 | State 1 → state 2 → state 1 |
| 4 | State 2 → state 3 |
| 5 | State 3 → state 2 → state 3 |
| 6 | State 3 → idle state |
| 7 | Idle state → state 3 → idle state |

**Table 2-2**

| **Set No.** | **Unallowable sets of one or more transitions** |
|---|---|
| 1 | State 1 → idle state |
| 2 | State 1 → state 3 |
| 3 | State 2 → idle state |
| 4 | State 3 → state 2 → state 1 |
| 5 | State 3 → state 1 |
| 6 | Idle state → state 3 → state 2 |
| 7 | Idle state → state 2 |

In some of the examples above, a conditional transition is described as being dependent on a following transition. For example, the transition from the idle state to state 3 is only allowable if the next transition is from state 3 to the idle state. Conditional transitions may equivalently be described as being dependent on (i.e. conditional on) a preceding transition. For example, saying that the transition from the idle state to state 3 is only allowable if followed by a transition back to the idle state is the same as saying that the transition from state 3 to state 2 is only allowable if preceded by the transition from state 2 to state 3. Any other preceding transition to state 3, when followed by a transition from state 3 to state 2, would not be allowable. In other words, once the FSM is in state 3, it can only have got there via an allowable transition if the preceding transition was from the idle state to state 3, or if the preceding transition was from state 2 to state 3. At that point in time, it cannot be determined if any error has occurred in the FSM. It is known that the route going from the idle state to state 3 to state 2 is not allowable, and that the route going from state 2 to state 3 to state 2 is allowable. So, once the FSM is in state 3, a transition from state 3 to state 2 is only allowable if it was preceded by the transition from state 2 to state 3. Thus, the transition from state 3 to state 2 can be thought of as being dependent on the preceding state (i.e., how the FSM got into state 3). In this case, the transition from the idle state to state 3 may not be listed as a conditional transition, as the conditionality has been shifted onto the transition from state 3 to state 2 which is dependent on preceding transitions. Thus, the list of allowable and unallowable routes can be written differently depending on whether the conditional transitions are described with respect to preceding transitions or following transitions.

All the features described above with reference to allowable and unallowable transitions apply equally to allowable and unallowable routes. For example, a route is either allowable, or it is unallowable. There is no other type of route. So, the unallowable routes can be determined from the allowable routes, and vice versa. The allowable and unallowable routes in the FSM are predetermined during the design phase of the FSM.

It can be determined whether the FSM comprises conditional transitions by looking at the length of the allowable or unallowable routes. For example, if all routes (allowable or unallowable routes) are only one transition long (i.e., the routes are sets of only one transition), then there are no conditional transitions in the FSM. If there is a route (an allowable or unallowable route) that comprises two or more transitions, then the FSM comprises at least one conditional transition.

The inventor has recognised that the occurrence of a fault in an FSM can be identified by checking whether a set of one or more transitions that have occurred between states of the FSM is allowable. If a set of one or more transitions occurs in an FSM that is not intended to occur during normal operation of the FSM (i.e. the set is not allowable), it can be determined that there is a fault in the FSM, i.e. that a fault has occurred in the operation of the FSM. The determined fault is not an error in the design of the FSM. Rather, it is a fault that has arisen after the FSM has been designed and tested (e.g. debugged). For example, if the FSM of figure 1 is run and a transition occurs from state 1 to state 3, this indicates that a fault has occurred in the FSM because there is no input for which the transition from state 1 to state 3 is supposed to happen. Whilst this method cannot determine whether an allowable set of one or more transitions has occurred from one state to another for the correct reasons (e.g. in response to the correct input), it can pick up on sets of one or more transitions that have occurred in the FSM which are never supposed to happen, regardless of the input. Detecting faults in the FSM based on unallowable sets of one or more transitions contributes to meeting industrial safety standards, such as ISO26262. Furthermore, detecting that a set of one or more transitions that is not allowable has occurred is simple to implement, and will not significantly negatively affect the performance of the FSM, e.g. in terms of latency, power consumption and/or silicon area.

For FSMs in which the allowability of each transition is independent of other transitions, the set of one or more transitions described herein need only to contain one transition. For FSMs containing conditional transitions, looking independently at one transition that has occurred in the FSM will not necessarily be enough to determine whether that transition is allowable. It may be necessary to consider a set of two or more transitions that have occurred.

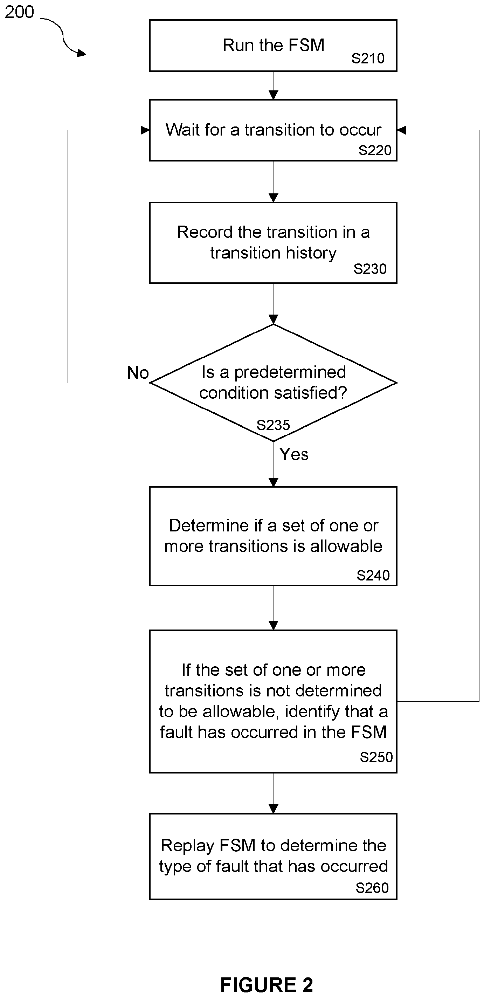

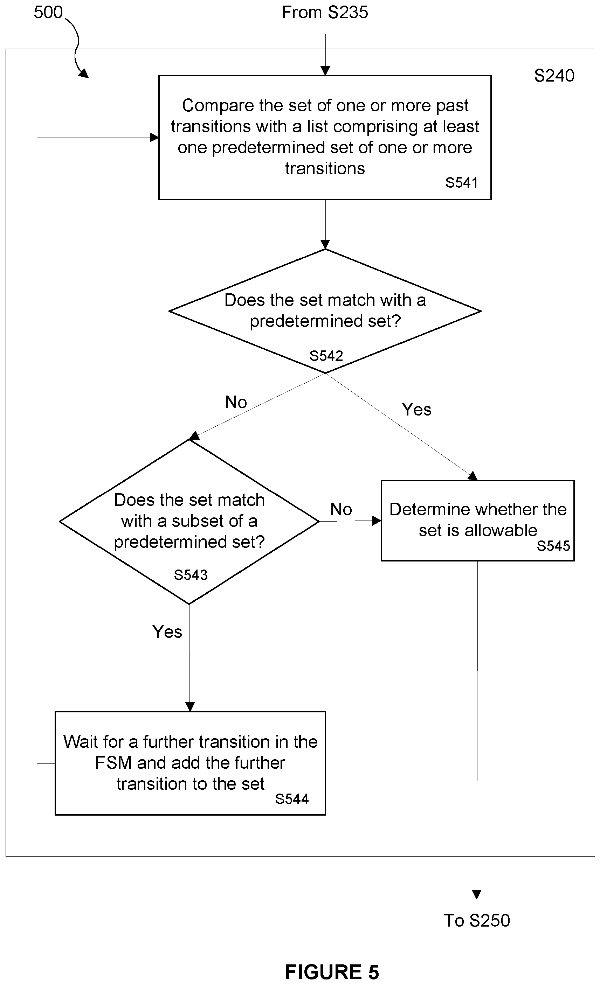

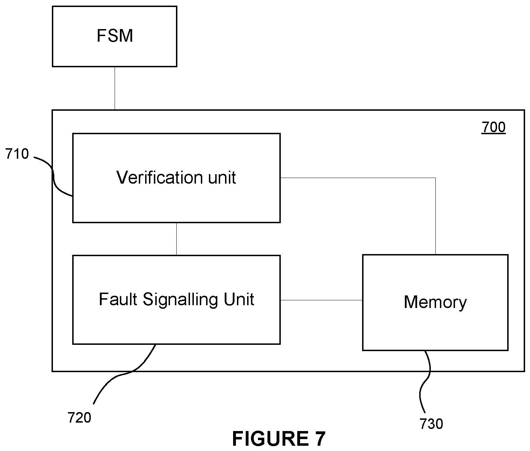

A method 200 for identifying that a fault has occurred in an FSM will now be described, with reference to figure 2 and figure 5. This method may be performed by the processing module 700 shown in figure 7. As described in more detail below, the processing module 700 comprises a verification unit 710, a fault signalling unit 720 and a memory 730. The verification unit 710 and the fault signalling unit 720 may be implemented in hardware, software or a combination thereof. The method described herein identifies a fault after it has occurred, i.e. it identifies errors in past (i.e. historical) transitions. A transition that has occurred between states of the FSM is referred to herein as a past transition.

The following fault-detection method 200 can be used with FSMs containing conditional transitions or FSMs without conditional transitions.

The method 200 can be implemented in parallel to the running of the FSM. In other words, the method need not interfere with the activity of the FSM. This avoids adding latency into the normal operation of the FSM.

The fault detection method described herein applies to an FSM that has already been designed. In other words, the FSM is no longer in a design-phase. For example, the FSM is not being debugged. Therefore, the allowable and unallowable routes have already been determined. As an optional step priorto step S210, the allowable routes may be determined. Additionally or alternatively, the unallowable routes may be determined. The unallowable routes can be determined from the allowable routes (and vice versa).

At step S210, the FSM is run. Running an FSM means that the FSM is active and responsive to input data. Running the FSM is distinct from designing and testing the FSM during a design-phase. For example, the FSM is not being tested in a debugging phase.

At step S220, the method waits for a transition to occur. That is, the FSM is allowed to run its course. Eventually, a transition will occur between states of the FSM.

The method may perform a check every clock cycle or predetermined interval to see if a transition has occurred. For example, the method may check whether a transition has occurred every predetermined interval. This may be performed every clock cycle, even if a transition may only occur every 10 clock cycles (for example).

At step S230, a record is kept of the transition that has occurred in the FSM in a transition history. Step S230 may be performed automatically when a transition occurs. In an example, a check to see whether a transition has occurred may be performed in response to detecting that a transition has been recorded in the transition history at step S230. Performing the step of recording the transition in the transition history (i.e. step S230) may prompt the system to proceed to step S235 or S240, without needing to perform a check every clock cycle or perform an active step of waiting for a transition to occur.

The transition history may be stored in memory. The transition history may be stored in a memory mapped register, for example. This may be suitable for when the method 200 is being performed in software. In another example, the transition history may be stored in memory local to the hardware. In some examples, the transition history may be made visible to software so that it may be updated or calibrated depending on the application of the FSM.

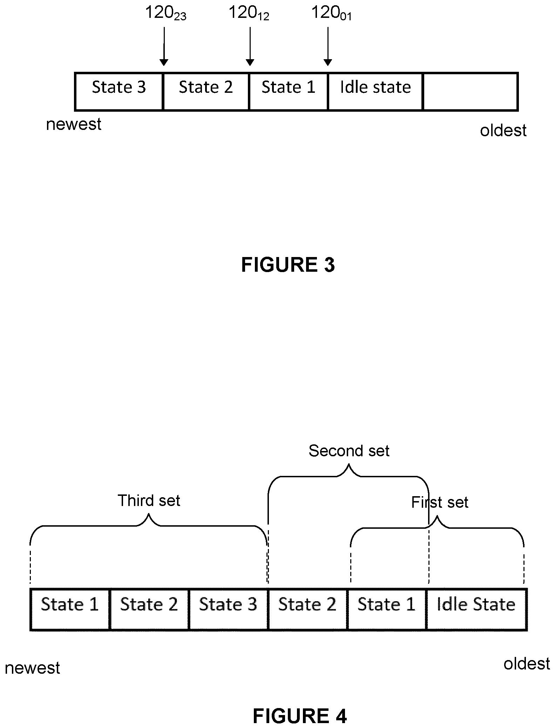

In an example, a transition may be recorded by recording the two states between which the transition occurred. For example, a transition history may be an ordered list of the states that the FSM has been in. Figure 3 shows an example transition history holding four states. The most recent state is to the left of the figure. In this example, the transition history is a history of states. Each past transition that has occurred can be determined from the order of the states in the history. Where the transition history stores states, the transition history must hold at least two states in order to record a transition. Each past transition 120 has been labelled in figure 3.

In another example, the transition history may be an ordered list of transitions. For example, the transition history in figure 3 may store the transitions 120₂₃, 120₁₂, and 120₀₁ instead of the states. When the transition is stored instead of the two states between which the past transition occurred, one fewer entry is taken up in the history.

The transition history may be configured to record up to a maximum number of transitions. For example, in figure 3, the transition history is configured to record up to a maximum of four transitions, corresponding to five states. There is a space in the memory of figure 3 for one more state (and therefore one more transition) to be recorded.

Once a transition has occurred between states of the FSM, the method may optionally check at step S235 if a predetermined condition is satisfied, before moving on to step S240. Some examples of such a predetermined condition are given below.

In one example, the predetermined condition is whether the FSM is in a default state. For example, the fault detection method may wait for the FSM to reach a default state (such as the idle state) before proceeding to step S240 to determine whether the route to get to that default state was allowable. Steps S220 and S230 may be performed in a loop until the FSM reaches a default state, which satisfies the predetermined condition at step S235. Then, the method may proceed to step S240 to determine whether the route that occurred to reach the default state was allowable.

In another example, the predetermined condition may relate to the number of transitions that have been recorded in the transition history. For example, the method may wait for a certain number of transitions to have occurred before checking whether they were allowable. Steps S230 and S220 may be performed in a loop, until the transition history has recorded a predetermined number of transitions at the condition at step S235 is satisfied.

Once the predetermined conditions, if any, have been satisfied at step S235, the method proceeds to step S240.

In step S240 the processing module 700 (in particular, the verification unit 710) determines whether a set of one or more transitions that have occurred between states of the FSM is allowable. The transition history may be used at step S240 to check the allowability of multiple sets of one or more past transitions after they have occurred. In some examples, instead of checking the allowability of each set of one or more past transitions at step S240 as soon as it occurs (i.e. before the next set of one or more transitions occurs), multiple sets of one or more past transitions can be recorded in the transition history and then each set of one or more past transitions in the history can be checked at step S240 with reference to the transition history.

Once each set of one or more past transitions in the history has been determined to be allowable or not allowable at step S240, the history may be cleared to make space for new transitions. Alternatively, the oldest recorded set of one or more transitions may be dropped from the history to make space for a new one. If the set of one or more transitions is determined to be unallowable, its transition history may be temporarily stored in a buffer for further analysis, as will be described in more detail below.

The details of an example implementation of step S240 are shown in figure 5.

At step S541, the set of one or more past transitions is compared with a list comprising at least one predetermined set of one or more transitions, also referred to herein as a predetermined route. The at least one route is predetermined in the sense that it was known prior to the running of the FSM.

The at least one predetermined route may be an allowable route. The at least one predetermined route may be an unallowable route. In some examples, the list may comprise only allowable routes, or only unallowable routes. The set of one or more past transitions is compared with entries of the list (or the entry of the list, if the list only comprises one entry) to determine whether the set of one or more past transitions matches any of the entries. This may be performed in any suitable manner. For example, the set of one or more past transitions may be compared with every entry of the list until a match is found. Alternatively, the set of one or more past transitions may be compared only with the entries of the list that start with the state at which the set of one or more past transitions started.

If the FSM does not comprise any conditional transitions, then the predetermined routes will only comprise one transition. In this case, the allowable routes are equivalent to allowable transitions, and the unallowable routes are equivalent to unallowable transitions. For example, the allowable routes for the FSM having the state diagram 100 shown in figure 1 are the same as the allowable transitions in the left-hand column of table 1, and the unallowable routes for the FSM having the state diagram 100 shown in figure 1 are the same as the unallowable transitions in the right-hand column of table 1.

If the FSM comprises at least one conditional transition, then the list will comprise at least one predetermined route that contains two or more transitions. For example, set number 5 in table 2-1 shows an allowable route containing two transitions.

The list or lists may be stored in software or hardware. Whilst a list is referred to herein, it is to be understood that any type of data record may be used to indicate which routes are allowable and which are not, alternatively to a list (e.g., an array, a look-up table or a database).

At S542, a decision is made as to whether the set of one or more past transitions matches an entry of the list. A set of one or more past transitions can only be determined to match an entry of the list if the set of one or more past transitions and the entry of the list contain the same number of transitions. For example, a set of past transitions comprising state 1 to state 2 cannot match with a predefined route comprising the transitions state 1 to state 2 to state 3. In addition to being the same length, the set of past transitions and the predefined route also need to contain the same transitions in order to match with each other.

If at step S542, the set of one or more past transitions is found to match a predefined route, then the method proceeds to step S545 to determine whether the set of one or more past transitions is allowable. Depending on whether the list comprises allowable or unallowable routes, a different conclusion about whether the set of one or more past transitions is allowable will be made. In the case where the list comprises routes of exclusively one type (allowable or unallowable), the response to determining that the set of one or more past transitions is on the list will be the same every time. In other examples, the list may comprise at least one allowable route, and at least one unallowable route. In this case, a further step of determining whether the set of one or more past transitions matched with an allowable or an unallowable route is required in order to determine if the set of one or more past transitions is allowable.

In an example, the list comprises all the allowable routes in the FSM, and/or all the unallowable routes in the FSM. In the situation where the list comprises all the allowable routes, or all the unallowable routes, or both, it can always be determined whether the set of one or more past transitions that has occurred is allowable or unallowable based on a comparison between the set of one or more past transitions and the entries on the list.

For example, if the list comprises all the allowable routes, and a comparison between the set of one or more past transitions and the list shows that the set of one or more past transitions is the same as one of the entries on the list, then the set of one or more past transitions is determined to be allowable. If the set of one or more past transitions does not match any of the entries on the list, then it can be determined that the set of one or more past transitions is not one of the allowable routes. Therefore, the set of one or more past transitions must be unallowable.

In another example, the list comprises all the unallowable routes. If a comparison between the set of one or more past transitions and the list shows that the set of one or more past transitions is the same as one of the entries on the list, then the set of one or more past transitions is determined to be unallowable. If the set of one or more past transitions does not match any of the entries on the list, then it can be determined that the set of one or more past transitions is not one of the unallowable routes. Therefore, the set of one or more past transitions must be allowable.

The list does not have to comprise all the allowable routes in the FSM, or all the unallowable routes in the FSM to be able to conclude that a set of one or more past transitions is allowable to within a certain error bound. For example, in large FSMs there may be thousands of allowable routes and thousands of unallowable routes. It may be the case that not all the allowable or unallowable routes are included in the list. Out of the thousands of allowable and unallowable routes, there may be a subset of those which are much more likely to occur. The list may comprise only the allowable or unallowable routes that are most likely to occur. Put another way, the list may comprise all allowable or unallowable routes minus the routes that are extremely unlikely to occur. When performing the comparison with such a list, for example with a list of most of the likely allowable routes, there is a chance that the set of one or more past transitions that has occurred is not on the list but is still allowable. A conclusion as to whether the set of one or more past transitions is allowable may be based on the probability of the set of one or more past transitions being allowable or not allowable.

The list may comprise whichever route type (allowable or unallowable) of which there are the fewest. This applies regardless of whether the list comprises all allowable routes and/or all unallowable routes, or only a subset of them. For example, if an FSM has a total of five allowable routes, and a total of fifteen unallowable routes, then the list may be chosen to comprise all allowable routes, rather than all unallowable routes. This may make it faster to determine whether the set of one or more past transitions is allowable or not. In the example FSM 100 shown in figure 1 and table 1, a set of one past transition is preferably compared with the list comprising the allowable routes, because the list comprising the allowable routes contains fewer entries than the list comprising the unallowable routes.

In another example, the set of one or more past transitions may be compared with the list comprising the fewest entries starting with the first state in the set of one or more past transitions. For example, there may be more allowable routes starting from a particular state than there are unallowable routes starting from that state, but the total number of allowable routes in the FSM may be fewer than the total number of unallowable routes in the FSM. In this case, it is preferable for the set of one or more past transitions to be compared with the longer list comprising the unallowable routes, rather than the shorter list comprising the allowable routes, because there are fewer unallowable routes starting with the first state in the set of one or more past transitions than there are allowable routes starting with that first state. In other words, preferably the set of one or more past transitions is compared with the list comprising the fewest entries relevant to the set of one or more past transitions.

If it is determined at step S542 that the set of past transitions does not match a predefined set, for example because the set of past transitions is not the same length as any of the predefined sets, or because the past transitions are not the same as the transitions in any of the predefined sets, then the method proceeds to step S543.

Step S543 checks whether the set of past transitions might be allowable if the FSM were to continue to another state. For example, if the set of past transitions only included a transition from state 1 to state 2, but the list comprises an allowable set of transitions that is state 1 to state 2 to state 3, the set of past transitions might be allowable if it continues to state 3. So, step S543 checks whether the set of past transitions matches with a subset of a predetermined set of transitions.

If the set of one or more past transitions matches with a subset of a predetermined route, then at step S544 the method waits for the FSM to transition into a further state. Once the FSM transitions into a further state, that further state is added to the set of past transitions. This may be done by recording the further state in the transition history. The process then repeats again from step S541, but this time with an updated set of past transitions which includes the further transition from step S544. In this way, the method can accommodate checking for conditional transitions in the sets of one or more past transitions.

If at step S543, the set of one or more past transitions is not found to match with a subset of a predetermined route, then at step S545 it can be determined whether the set of one or more past transitions is allowable, as described above. For example, if the list comprises allowable transitions, and at step S542 the set of past transitions is not found to match with an allowable transition, step S543 is checking that the set of past transitions cannot match with an allowable transition if it was allowed to continue to a further transition. If the set of past transitions does not match with a subset of an allowable route, then there is no chance that that set of past transitions is allowable, regardless of the next transition the FSM makes. In that case, depending on whether the list contained allowable or unallowable sets of transitions, the set of past transitions can be categorised as allowable or unallowable.

In step S250, in response to determining that the set of one or more past transitions is not allowable, the processing module 700 (in particular, the fault signalling unit 720) identifies that a fault has occurred in the FSM. For example, at step S250, if the set of one or more past transitions is determined not to be allowable, an error message may be raised. The error message may be picked up by a control system in the hardware or external to the hardware. If the set of one or more past transitions is determined to be allowable, no error message is raised.

In other examples, the processing module 700 may react differently to identifying that a fault has occurred in the FSM. For example, additionally or alternatively to raising an error message, if a set of one or more past transitions is determined to be unallowable, optionally at step S260, the method may further comprise replaying the FSM from the state at which the set of one or more past transitions started. If the FSM exhibits the same set of one or more transitions as the unallowable set of one or more past transitions, then it can be determined that the fault that gave rise to the first unallowable set of one or more past transitions is a stuck-at-fault. If, during the replay, the FSM exhibits a different set of one or more transitions to the set of one or more past transitions that was unallowable, then it may be determined that the fault that gave rise to the first unallowable set of one or more past transitions was a transient fault. This information may be submitted with the fault signal to the control system.

Steps S220 to S260 may then be repeated for the next transition that occurs in the FSM at step S220. In the case where multiple transitions were recorded in the transition history before proceeding to step S240, steps S240 to S260 are repeated for each transition in the transition history.

In some examples, it may not be necessary to record each transition in a transition history. For example, if the FSM does not comprise any conditional transitions, and so each set or route above only contains one transition, the method may determine whether the transition that has occurred is allowable each time a transition occurs. Once a transition has been determined to be allowable or not allowable, the transition may be discarded.

There are some constraints that apply to the size of the set that can be determined to be allowable based on the size of the transition history and the list of allowable and unallowable routes, as will be explained below.

The number of past transitions in a set that can be determined to be allowable is constrained to be equal to or greater than the number of transitions in the smallest predefined set in the list. This is because it is only possible to determine whether a set of one or more past transitions is allowable if there is at least one predefined set in the list that contains the same number of transitions as the set of one of more past transitions.

For example, if an FSM is designed such that the only allowable routes in the FSM are routes comprising two transitions (e.g. state 1 to state 2 to state 3), it is not possible to determine whether a set of only one transition that has occurred (e.g. state 1 to state 2) is allowable because the list against which the set will be compared does not comprise a set with only one transition.

So, one of the predetermined conditions that may be checked at step S235 is whether the number of past transitions in the set of one or more past transitions is equal to the number of transitions in at least one of the predefined routes. Steps S220 and S230 may loop around until this condition is satisfied.

If the list of allowable or unallowable routes comprises a route containing only one transition, then this condition will be satisfied with a set containing just one past transition. If the FSM does not contain any conditional transitions, it will always be the case that the number of transitions in the set of one or more past transitions is equal to or greater than the number of transitions in the smallest predetermined route, because the smallest predetermined route contains one transition.

Each time steps S220 and S230 occur, the transition that has just occurred can be added to the set of one or more past transitions that is going to be tested at step S240. Once it has been determined that the set of one or more past transitions is at least long enough to compare the set with at least one predefined route in the list, the method can proceed to step S240.

As explained above, the transitions that have occurred may be recorded in a transition history. When the FSM contains at least one conditional transition, it may be necessary to record the transitions that have occurred in the transition history (e.g. at step S230). The maximum number of transitions that the transition history can record defines the maximum number of transitions in the set of past transitions that can be determined to be allowable. If this is not the case, then it may not be possible to determine whether a set of transitions is allowable because the whole length of the set is not recorded in the transition history. For example, a set of five transitions that have occurred cannot be determined to be allowable if the transition history is only able to record the last four transitions.

Preferably, the maximum number of transitions that the transition history can record is the same as the number of transitions in the largest predefined set of transitions in the list.

### Example

The steps described above with reference to figures 2 and 5 will now be described in the context of an example based on an FSM having the state diagram 600 shown in figure 6. Figure 4 shows an example transition history comprising six states and recording five transitions. In this example, the maximum number of transitions that can be represented in the transition history is five. The sets indicated in figure 4 are example sets that can be determined to be allowable.

The FSM is run at step 210. The first transition to occur at step S220 in this example is the transition from the idle state to state 1. So, the first set comprises one transition 620₀₁. This transition is recorded in the transition history at step S230.

In this example, the predetermined condition that is checked at step S235 is whether the number of past transitions that have occurred is equal to the number of transitions in one of the at least one predefined set of one or more transitions. In this case, as the allowable and unallowable transitions for the FSM shown in table 2-1 and 2-2 comprise at least one set comprising only one transition, any set comprising one past transition satisfies the requirement of being at least as long as one of the predetermined sets in the list. So, the method can proceed to step S240, which involves the steps shown in figure 5.

At step S541, the first set is compared with the list in either table 2-1 or table 2-2 (or both) to determine whether the first set is allowable. Taking table 2-1 as an example, the transition 620₀₁ matches set number 1 in the list of allowable transitions. So, the answer to step S542 is 'yes'. At step S545, the first set comprising transition 620₀₁ is determined to be allowable, because the predetermined set that it matched with in step S542 is an allowable set. Therefore, at step S250, no fault is identified, e.g. no error message is raised, and the method repeats from step S220.

The same process applies to the second set, comprising one transition 620₁₂, depicted in figure 4. Each transition is added to the transition history as it occurs.

The third set that is determined to be allowable comprises two transitions: transition 620₃₂ and transition 620₂₁. Initially, it is not yet known that the third set is going to contain two transitions. The method starts with considering the third set as only containing the transition from state 3 to state 2.

At step S541, the third set comprising the transition 620sz is compared with the predetermined sets of one or more transitions. It can be seen from table 2-1 that there are two allowable sets of transitions starting from state 3: set 5 and set 6. Set 6 only comprises one transition, whereas set 5 comprises two transitions. At step S542, it is determined that the third set does not match set 6. It is also determined that the third set does not match set 5, because the third set is not the same length as set 5. So, the answer to step S542 is "no". However, even though the third set does not match set 6, it still might match set 5 if the FSM proceeds to transition from state 2 back to state 3. At this point, the system cannot be sure as to whether the FSM is faulty or not.

Since the answer to step S542 is "no", the method proceeds to step S543, where it is determined whether the third set matches a subset of a predetermined set. The transition from state 3 to state 2 does match a subset of the fifth set. So, the answer to step S543 is "yes".

Therefore, the method proceeds to step S544 and waits for a further transition to occur. This is equivalent to returning to step S220 in figure 2. The next transition to occur is the transition from state 2 to state 1. This transition is recorded in the transition history at step S230. The further transition is added to the third set. So, the third set now comprises transition 620₃₂ and 620₂₁.

The method then returns to step S541 and repeats. At step S542, there is no entry on the list in table 2-1 that matches with the third set of transitions of state 3 to state 2 to state 1. So, the answer to step S542 is "no". At step S543, the third set of transitions is compared with a subset of the predetermined sets. The third set does not match with a subset of any of the predetermined sets in table 2-1. In other words, there is no other entry in table 2-1 that would result in the third set of transitions being allowable if the FSM proceeded with another transition. Therefore, the answer to step S543 is "no". At step S545, the third set comprising transition 620₃₂ and 620₂₁ is determined not to be allowable.

At step S250, a fault in the FSM is identified, and an error message may be raised.

As indicated by this example, the set of one or more past transitions that are determined to be allowable may be of varying length, depending on the list of predefined sets of transitions. The set length may also increase as the method proceeds through steps S541 to S544. The transition history allows the method to keep track of past transitions which may be needed to determine whether a set of multiple transitions is allowable.

The processing module 700 for identifying that a fault has occurred in an FSM will now be described, with reference to figure 7. The processing module 700 may be a part of the hardware used to model the finite-state machine. In another example, the processing module may be implemented separately to the hardware used to model the FSM. The processing module is configured to perform the steps of method 200 (including method 500).

The processing module comprises a verification unit 710. The verification unit is configured to determine whether a set of one or more transitions that have occurred between states of the FSM is allowable. The verification unit receives data from the FSM indicating the transitions that have occurred between states of the FSM during run-time. The verification unit also has access to a list comprising at least one predefined set of one or more transitions. As the list is predetermined prior to running the FSM, the processing module 700 may store the list in local memory or a register within the processing module. The verification unit is configured to determine whether a set of one or more transitions that have occurred between states of the FSM is allowable in dependence on the list comprising at least one predefined set of one or more transitions. For example, the verification unit may compare the set of one or more transitions that have occurred between states of the FSM with the list comprising the at least one predefined set of one or more transitions. In response to the comparison, the verification unit may determine that the set of one or more transitions is allowable or is not allowable. For example, if the verification unit compares the set of one or more transitions that have occurred with a list comprising unallowable sets of one or more transitions, and determines that the set that has occurred matches an unallowable set, then the verification unit determines that the set that has occurred is not allowable.

As explained above, the size of the set of one or more transitions that can be determined to be allowable depends on the size of the predefined sets in the list of one or more predefined sets of one or more transitions. The verification unit cannot determine the allowability of a set of transitions that have occurred in the FSM if the list comprising at least one predefined set of one or more transitions does not contain a set with the same number of transitions as the set of transitions that have occurred. So, the verification unit may be configured to perform said determining in response to detecting that the number of transitions that have occurred is equal to the number of transitions in one of the at least one predefined set of one or more transitions.

The processing module may comprise a memory 730. The memory is configured to record the set of one or more transitions that have occurred between states of the FSM in a transition history. The memory may have a maximum capacity and so only be able to record up to a maximum number of transitions. Preferably, the maximum number of transitions that the memory can record is determined based on the at least one predefined set of one or more transitions. For example, the maximum number of transitions that the memory can record is equal to the number of transitions in the largest predefined set. Preferably, the number of transitions in the set of one or more transitions that the verification unit can determine to be allowable does not exceed the maximum number of transitions that the memory can record.

The verification unit is thus configured to perform step S240, including steps S541 to S545, described above and in relation to figure 5.

The processing module further comprises a fault signalling unit 720. The fault signalling unit is configured to communicate with the verification unit. The fault signalling unit may also be configured to communicate with the verification memory 730. The fault signalling unit identifies that a fault has occurred in the FSM in response to an indication from the verification unit. For example, if the verification unit indicates that the set of one or more transitions that has occurred between states of the FSM is not allowable, the fault verification unit identifies that a fault has occurred in the FSM. When the fault signalling unit identifies that a fault has occurred in the FSM, it may output an error message, as indicated at step S250 in figure 2. For example, the fault signalling unit may signal to a system external to the processing module that a fault has occurred in the FSM.

The system may respond to such an error message in any suitable manner. In one example, the fault signalling unit may be further configured to classify the type of fault that has occurred in the FSM. For example, in response to identifying that a fault has occurred in the FSM, the fault signalling unit may replay the FSM from a first state corresponding to a first transition in the set of one or more transitions that was determined not to be allowable by the verification unit. For example, if the set of one or more transitions that was not determined to be allowable comprised the transition from state 1 to state 3, the fault signalling unit may run the FSM again, starting from state 1. If the same transition occurs in the FSM (e.g. the FSM proceeds from state 1 to state 3 again), then it may be determined that the fault that has occurred in the FSM is a stuck-at-fault. If the same error does not occur, then it may be determined that the fault that has occurred in the FSM is a transient fault. In the replay of the FSM, the input data that was used when identifying that the set of one or more transitions is not allowable may be used again when starting the FSM from the first state.

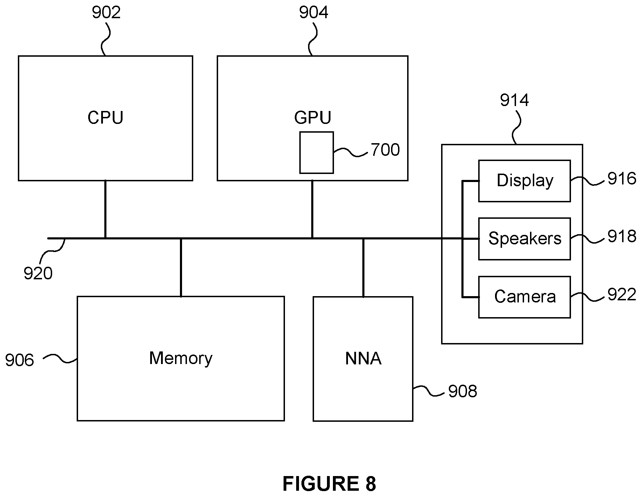

Figure 8 shows a computer system in which the processing module described herein may be implemented. The computer system comprises a CPU 902, a GPU 904, a memory 906, a neural network accelerator (NNA) 908 and other devices 914, such as a display 916, speakers 918 and a camera 922. The processing module 700 is implemented on the GPU 904. In other examples, one or more of the depicted components may be omitted from the system, and/or the processing module 700 may be implemented on the CPU 902 or within the NNA 908. The components of the computer system can communicate with each other via a communications bus 920.

The processing module of figure 7 is shown as comprising a number of functional blocks. This is schematic only and is not intended to define a strict division between different logic elements of such entities. Each functional block may be provided in any suitable manner. It is to be understood that intermediate values described herein as being formed by a processing module need not be physically generated by the processing module at any point and may merely represent logical values which conveniently describe the processing performed by the processing module between its input and output.

The processing module described herein may be embodied in hardware on an integrated circuit. The processing module described herein may be configured to perform any of the methods described herein. Generally, any of the functions, methods, techniques or components described above can be implemented in software, firmware, hardware (e.g., fixed logic circuitry), or any combination thereof. The terms "module," "functionality," "component", "element", "unit", "block" and "logic" may be used herein to generally represent software, firmware, hardware, or any combination thereof. In the case of a software implementation, the module, functionality, component, element, unit, block or logic represents program code that performs the specified tasks when executed on a processor. The algorithms and methods described herein could be performed by one or more processors executing code that causes the processor(s) to perform the algorithms/methods. Examples of a computer-readable storage medium include a random-access memory (RAM), read-only memory (ROM), an optical disc, flash memory, hard disk memory, and other memory devices that may use magnetic, optical, and other techniques to store instructions or other data and that can be accessed by a machine.

The terms computer program code and computer readable instructions as used herein refer to any kind of executable code for processors, including code expressed in a machine language, an interpreted language or a scripting language. Executable code includes binary code, machine code, bytecode, code defining an integrated circuit (such as a hardware description language or netlist), and code expressed in a programming language code such as C, Java or OpenCL. Executable code may be, for example, any kind of software, firmware, script, module or library which, when suitably executed, processed, interpreted, compiled, executed at a virtual machine or other software environment, cause a processor of the computer system at which the executable code is supported to perform the tasks specified by the code.

A processor, computer, or computer system may be any kind of device, machine or dedicated circuit, or collection or portion thereof, with processing capability such that it can execute instructions. A processor may be or comprise any kind of general purpose or dedicated processor, such as a CPU, GPU, NNA, System-on-chip, state machine, media processor, an application-specific integrated circuit (ASIC), a programmable logic array, a field-programmable gate array (FPGA), or the like. A computer or computer system may comprise one or more processors.

It is also intended to encompass software which defines a configuration of hardware as described herein, such as HDL (hardware description language) software, as is used for designing integrated circuits, or for configuring programmable chips, to carry out desired functions. That is, there may be provided a computer readable storage medium having encoded thereon computer readable program code in the form of an integrated circuit definition dataset that when processed (i.e. run) in an integrated circuit manufacturing system configures the system to manufacture a processing module configured to perform any of the methods described herein, or to manufacture a processing module comprising any apparatus described herein. An integrated circuit definition dataset may be, for example, an integrated circuit description.

Therefore, there may be provided a method of manufacturing, at an integrated circuit manufacturing system, a processing module as described herein. Furthermore, there may be provided an integrated circuit definition dataset that, when processed in an integrated circuit manufacturing system, causes the method of manufacturing a processing module to be performed.

An integrated circuit definition dataset may be in the form of computer code, for example as a netlist, code for configuring a programmable chip, as a hardware description language defining hardware suitable for manufacture in an integrated circuit at any level, including as register transfer level (RTL) code, as high-level circuit representations such as Verilog or VHDL, and as low-level circuit representations such as OASIS (RTM) and GDSII. Higher level representations which logically define hardware suitable for manufacture in an integrated circuit (such as RTL) may be processed at a computer system configured for generating a manufacturing definition of an integrated circuit in the context of a software environment comprising definitions of circuit elements and rules for combining those elements in order to generate the manufacturing definition of an integrated circuit so defined by the representation. As is typically the case with software executing at a computer system so as to define a machine, one or more intermediate user steps (e.g. providing commands, variables etc.) may be required in order for a computer system configured for generating a manufacturing definition of an integrated circuit to execute code defining an integrated circuit so as to generate the manufacturing definition of that integrated circuit.

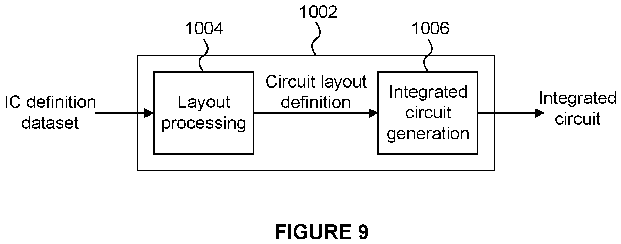

An example of processing an integrated circuit definition dataset at an integrated circuit manufacturing system so as to configure the system to manufacture a processing module will now be described with respect to Figure 9.

Figure 9 shows an example of an integrated circuit (IC) manufacturing system 1002 which is configured to manufacture a processing module as described in any of the examples herein. In particular, the IC manufacturing system 1002 comprises a layout processing system 1004 and an integrated circuit generation system 1006. The IC manufacturing system 1002 is configured to receive an IC definition dataset (e.g. defining a processing module as described in any of the examples herein), process the IC definition dataset, and generate an IC according to the IC definition dataset (e.g. which embodies a processing module as described in any of the examples herein). The processing of the IC definition dataset configures the IC manufacturing system 1002 to manufacture an integrated circuit embodying a processing module as described in any of the examples herein.

The layout processing system 1004 is configured to receive and process the IC definition dataset to determine a circuit layout. Methods of determining a circuit layout from an IC definition dataset are known in the art, and for example may involve synthesising RTL code to determine a gate level representation of a circuit to be generated, e.g. in terms of logical components (e.g. NAND, NOR, AND, OR, MUX and FLIP-FLOP components). A circuit layout can be determined from the gate level representation of the circuit by determining positional information for the logical components. This may be done automatically or with user involvement in orderto optimise the circuit layout. When the layout processing system 1004 has determined the circuit layout it may output a circuit layout definition to the IC generation system 1006. A circuit layout definition may be, for example, a circuit layout description.

The IC generation system 1006 generates an IC according to the circuit layout definition, as is known in the art. For example, the IC generation system 1006 may implement a semiconductor device fabrication process to generate the IC, which may involve a multiple-step sequence of photo lithographic and chemical processing steps during which electronic circuits are gradually created on a wafer made of semiconducting material. The circuit layout definition may be in the form of a mask which can be used in a lithographic process for generating an IC according to the circuit definition. Alternatively, the circuit layout definition provided to the IC generation system 1006 may be in the form of computer-readable code which the IC generation system 1006 can use to form a suitable mask for use in generating an IC.

The different processes performed by the IC manufacturing system 1002 may be implemented all in one location, e.g. by one party. Alternatively, the IC manufacturing system 1002 may be a distributed system such that some of the processes may be performed at different locations, and may be performed by different parties. For example, some of the stages of: (i) synthesising RTL code representing the IC definition dataset to form a gate level representation of a circuit to be generated, (ii) generating a circuit layout based on the gate level representation, (iii) forming a mask in accordance with the circuit layout, and (iv) fabricating an integrated circuit using the mask, may be performed in different locations and/or by different parties.

In other examples, processing of the integrated circuit definition dataset at an integrated circuit manufacturing system may configure the system to manufacture a processing module without the IC definition dataset being processed so as to determine a circuit layout. For instance, an integrated circuit definition dataset may define the configuration of a reconfigurable processor, such as an FPGA, and the processing of that dataset may configure an IC manufacturing system to generate a reconfigurable processor having that defined configuration (e.g. by loading configuration data to the FPGA).

In some embodiments, an integrated circuit manufacturing definition dataset, when processed in an integrated circuit manufacturing system, may cause an integrated circuit manufacturing system to generate a device as described herein. For example, the configuration of an integrated circuit manufacturing system in the manner described above with respect to Figure 9 by an integrated circuit manufacturing definition dataset may cause a device as described herein to be manufactured.

In some examples, an integrated circuit definition dataset could include software which runs on hardware defined at the dataset or in combination with hardware defined at the dataset. In the example shown in Figure 9, the IC generation system may further be configured by an integrated circuit definition dataset to, on manufacturing an integrated circuit, load firmware onto that integrated circuit in accordance with program code defined at the integrated circuit definition dataset or otherwise provide program code with the integrated circuit for use with the integrated circuit.

The implementation of concepts set forth in this application in devices, apparatus, modules, and/or systems (as well as in methods implemented herein) may give rise to performance improvements when compared with known implementations. The performance improvements may include one or more of increased computational performance, reduced latency, increased throughput, and/or reduced power consumption. During manufacture of such devices, apparatus, modules, and systems (e.g. in integrated circuits) performance improvements can be traded-off against the physical implementation, thereby improving the method of manufacture. For example, a performance improvement may be traded against layout area, thereby matching the performance of a known implementation but using less silicon. This may be done, for example, by reusing functional blocks in a serialised fashion or sharing functional blocks between elements of the devices, apparatus, modules and/or systems. Conversely, concepts set forth in this application that give rise to improvements in the physical implementation of the devices, apparatus, modules, and systems (such as reduced silicon area) may be traded for improved performance. This may be done, for example, by manufacturing multiple instances of a module within a predefined area budget.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein. In view of the foregoing description it will be evident to a person skilled in the art that various modifications may be made within the scope of the invention.

## Claims

1. A computer-implemented method of identifying that a fault has occurred in a finite-state machine (FSM), the method comprising:
determining whether a set of one or more transitions that have occurred between states of the FSM is allowable; and
in response to determining that the set of one or more transitions is not allowable, identifying that a fault has occurred in the FSM.

2. The method of claim 1, wherein said determining is performed in dependence on a data record comprising at least one predefined set of one or more transitions.

3. The method of claim 2, wherein said determining comprises:
comparing the set of one or more transitions that have occurred between states of the FSM with the data record comprising the at least one predefined set of one or more transitions; and
determining that the set of one or more transitions is not allowable in response to said comparison.

4. The method of claim 2 or 3, wherein a first group comprises predefined allowable sets of one or more transitions between states of the FSM, and a second group comprises predefined unallowable sets of one or more transitions between states of the FSM, and the data record comprises the sets of the group comprising the fewest predefined sets out of the first and second groups.

5. The method of any of claims 2 to 4, wherein the number of transitions in the set of one or more transitions that have occurred is equal to the number of transitions in one of the at least one predefined set of one or more transitions in the data record.

6. The method of any preceding claim, further comprising recording the set of one or more transitions that have occurred between states of the FSM in a transition history.

7. The method of claim 6, wherein said determining is performed in dependence on the transition history.

8. The method of claim 6 or 7, wherein the transition history is configured to record up to a maximum number of transitions,
optionally wherein the number of transitions in the set of one or more transitions that have occurred does not exceed the maximum number.

9. The method of claim 8 when dependent on claim 2, wherein the maximum number of transitions is determined based on the at least one predefined set of one or more transitions in the data record.

10. The method of claim 2, wherein said determining is performed in response to detecting that the number of transitions that have occurred is equal to the number of transitions in one of the at least one predefined set of one or more transitions in the data record.

11. The method of any preceding claim, wherein the method is performed whilst the FSM is active and responding to input data.

12. The method of any preceding claim, further comprising, in response to identifying that a fault has occurred in the FSM:
replaying the FSM from a first state corresponding to a first transition in the set of one or more transitions that have occurred; and
in response to determining that the same set of one or more transitions has occurred between states of the FSM, determining that the fault that has occurred is a stuck-at-fault.

13. A processing module configured to identify that a fault has occurred in a finite-state machine (FSM), the processing module comprising:
a verification unit configured to determine whether a set of one or more transitions that have occurred between states of the FSM is allowable; and
a fault signalling unit configured to identify that a fault has occurred in the FSM if the verification unit indicates that the set of one or more transitions is not allowable.

14. Computer readable code configured to cause the method of any of claims 1 to 12 to be performed when the code is run.

15. A computer readable storage medium having stored thereon an integrated circuit definition dataset that, when processed in an integrated circuit manufacturing system, configures the integrated circuit manufacturing system to manufacture a processing module as claimed in claim 13.
